# FASCICULE DE BREVET EUROPEEN

(11) **EP 2 058 947 B1**
(45) Date de publication et mention de la délivrance du brevet: **23.09.2015**
(21) Numéro de dépôt: 08168497.9
(22) Date de dépôt: 06.11.2008
(51) Int. Cl.: H03D 7/14, H03H 11/32, H03F 1/22, H03F 3/60, H03F 3/62, H03F 3/21

(54) **Structure de balun actif réciproque à large bande passante**
Aktive reziproke Breitband-Balunstruktur
Broadband reciprocal active balun structure

(30) Priorité: 09.11.2007 FR 0707855
(43) Date de publication de la demande: 13.05.2009
(73) Titulaire: THALES, 92200 Neuilly-sur-Seine (FR)
(72) Inventeur: Plaze, Jean-Michel, 78390 BOIS D'ARCY (FR); Dueme, Philippe, 91400 ORSAY (FR); Mallet-Guy, Benoît, 75015 PARIS (FR)
(74) Mandataire: Lucas, Laurent Jacques

(56) Documents cités:
- WO-A-02/41442
- FR-A- 2 895 168

## Description

La présente invention concerne le domaine des dispositifs électroniques connus sous le nom de "baluns", et plus particulièrement le domaine des mélangeurs à large bande passante, employés notamment dans les chaînes d'émission et de réception radioélectriques, et réalisés à partir de baluns.

Il existe aujourd'hui dans l'industrie des besoins important en termes de mélangeurs large bande. Ces circuits sont utilisés dans certaines chaînes de réception ou d'émission. Par ailleurs, de nombreuses architectures sont envisageables pour réaliser des mélangeurs. Parmi celles-ci on distingue en particulier les structures dites "équilibrées" ou "doublement équilibrées" qui offrent les meilleures performances en termes de réjection de fréquences parasites et de très bons isolements entre voies. II est connu de réaliser un mélangeur doublement équilibré en utilisant un pont de transistors à effet de champ ou un pont de diodes. Par ailleurs pour réaliser un tel circuit en technologie MMIC (Circuit Intégré Monolithique Micro-ondes ou "**M**onolithic **M**icrowave **I**ntégrated **C**ircuit" selon la terminologie anglo-saxonne), capable de fonctionner sur une large bande de fréquence, il faut disposer d'unités fonctionnelles connues sous le nom de « baluns » large bande.

Le terme "balun", qui est une contraction de l'expression anglo-saxonne "**bal**anced - **un**balanced", désigne de manière générale un dispositif à trois accès capable soit de diviser un signal d'entrée en deux signaux de sortie de même amplitude et déphasés entre eux de 180°, et de réaliser ainsi un circuit diviseur de puissance avec sorties en opposition de phase (balun diviseur), soit de recombiner deux signaux d'entrée de sorte que le signal de sortie représente la différence des signaux d'entrée et de réaliser alors un circuit combineur avec entrées en opposition de phase (balun recombineur).

Actuellement, il existe deux approches connues pour réaliser un balun.

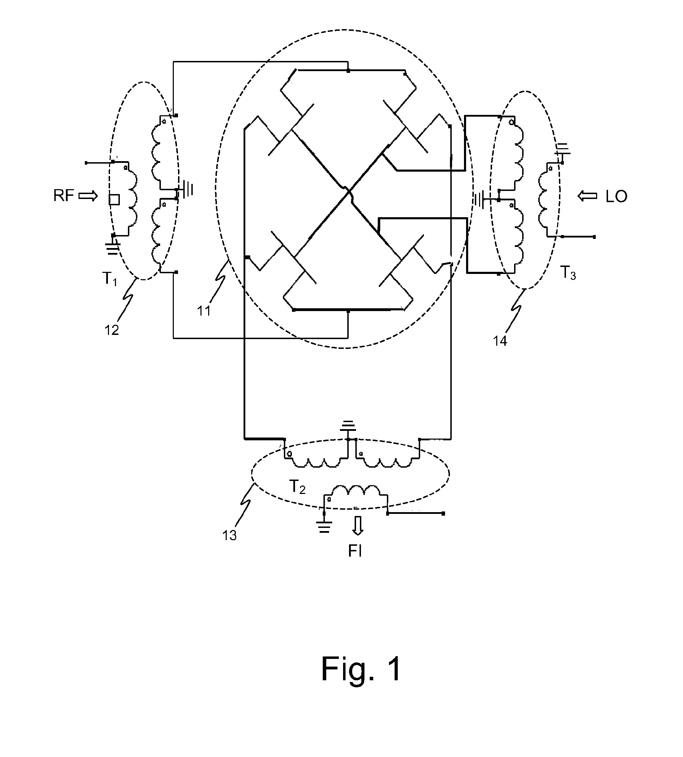

La première approche illustrée par la figure 1, consiste à réaliser des transformateurs 12, 13 et 14 à point milieu pour attaquer par exemple un pont de transistors à effet de champ 11. Un tel dispositif, passif et réciproque, permet avantageusement de réaliser les deux types de fonctions précitées. Cependant un tel circuit fonctionnant en hyperfréquences est très difficile à réaliser en technologie planaire. De plus, il ne permet pas de travailler sur de très large bande de fréquence (au delà de 2 à 3 octaves) et de descendre bas en fréquence (f < 1 GHz).

La seconde approche consiste à utiliser un balun actif, réalisé à partir d'une structure distribuée, telle que celle décrite dans la demande de brevet français déposée par la demanderesse le 21 /12/ 2005 et publiée sous le numéro 2 895 168. Ce balun actif combine deux structures équilibrées, l'une d'elles est composée de cellules amplificatrices de type "cascade" ou "Darlington", l'autre étant composé de cellules amplificatrices de type "cascode". Ce montage particulier permet notamment de régler le problème de déséquilibre de gain entre voies existant généralement dans les montages classiques, déséquilibre entre les deux voies de sorties (cas d'un montage diviseur) ou entre les deux voies d'entrées (cas d'un montage combineur). II permet également d'assurer un déphasage de 180° entre voies.

Cette seconde approche permet de réaliser des baluns fonctionnant à des fréquences basses et sur des bandes de fréquences beaucoup plus larges (de l'ordre de la décade ou plus) que les autres dispositifs existants. Elle constitue donc une solution plus avantageuse que la première approche. Cependant, les structures actives réalisées de cette façon ne sont pas réciproques. Il est donc malheureusement nécessaire de réaliser deux structures différentes pour réaliser un diviseur et un combineur. L'utilisation de ce type de structure dans un mélangeur a pour conséquence de rendre le mélangeur unilatéral.

Ainsi, quelle que soit l'approche retenue, il n'est pas possible, à l'heure actuelle, de concevoir un balun actif fonctionnant sur une très large bande de fréquence (de la classe de la décade) qui soit réciproque et qui puisse traiter les basses fréquences (f ≤ 1 GHz).

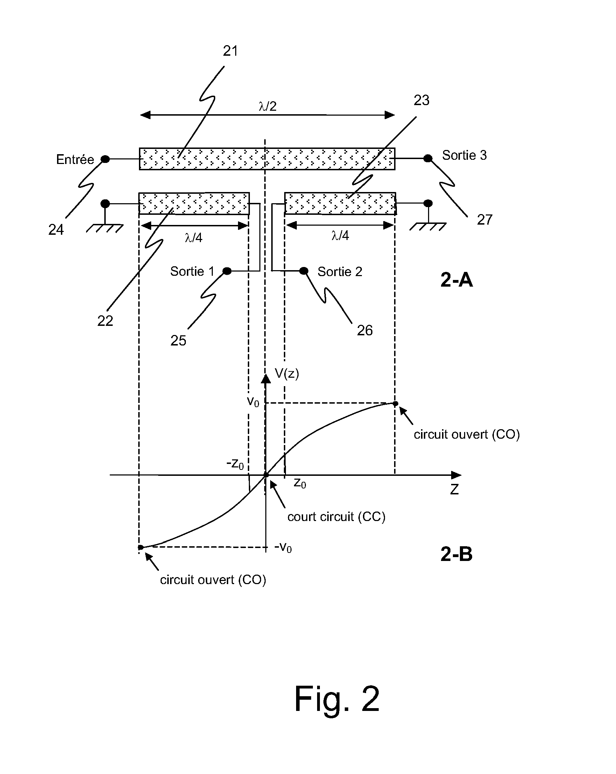

Par suite si l'on veut réaliser un balun réciproque, on est conduit à l'heure actuelle à utiliser un balun passif constitué par exemple d'une structure du type de celle du balun de Marchand. Une telle structure, connue par ailleurs et illustrée par la figure 2, est basée sur des couplages de lignes, une ligne principale 21 de longueur équivalente à λ/2 et deux lignes 22 et 23 couplées à la ligne principale, de longueurs λ/4, et agencées de façon à fournir sur leurs sorties respectives 25 et 26 des signaux de même valeur en module et en opposition de phase. Elle permet avantageusement de réaliser des baluns réciproques. Cependant, l'emploi de coupleurs passifs, introduit des problèmes d'encombrement en particulier lorsque l'on veut travailler à des fréquences relativement basses (autour de 1 GHz), le coupleur passif ayant nécessairement une longueur équivalente à λ/2 à la fréquence centrale de travail du dispositif mélangeur dans lequel il est intégré. Cela rend ce type de structure difficilement intégrable sur des technologies MMIC. De plus, du fait de sa structure, un tel balun ne peut donc être utilisé pour des applications large bande (plusieurs octaves).

Un but de l'invention est de proposer une solution pour réaliser une structure de type balun qui soit à la fois réciproque et large bande (bande passante supérieure à l'octave).

A cet effet, l'invention a pour objet un balun actif réciproque comportant:
- un élément balun diviseur actif comportant trois lignes, formant deux structures amplificatrices distribuées, chaque structure comportant une première ligne de transmission commune avec l'autre structure, la première structure distribuée étant réalisée au moyen de cellules amplificatrices de type "cascode" réparties, connectées à la première ligne de transmission et à une deuxième ligne de transmission de façon à permettre un couplage actif non réciproque du signal de la première ligne à la deuxième ligne, la seconde structure distribuée étant réalisée au moyen de cellules amplificatrices de type "Darlington" réparties, connectées entre la première ligne et une troisième ligne de transmission, de façon à permettre un couplage actif non réciproque du signal de la première ligne à la troisième ligne;
- un élément balun actif combineur comportant trois lignes, formant deux structures amplificatrices distribuées, chaque structure comportant une première ligne de transmission commune avec l'autre structure, la première structure distribuée étant réalisée au moyen de cellules amplificatrices de type "cascode" réparties, connectées à la première ligne de transmission et à une deuxième ligne de transmission de façon à permettre un couplage actif non réciproque du signal de la deuxième ligne à la première ligne, la seconde structure distribuée étant réalisée au moyen de cellules amplificatrices de type "Darlington" réparties, connectées à la première ligne de transmission et à une troisième ligne de transmission de façon à permettre un couplage actif non réciproque du signal de la troisième ligne à la première ligne;
   caractérisé en ce que:
- les éléments balun diviseur et balun combineur sont agencés de façon à ce que la ligne commune de l'élément balun diviseur soit connecté à la ligne commune de l'élément balun combineur à travers une première capacité afin de constituer une première ligne de transmission unique, que la troisième ligne de l'élément balun diviseur soit connecté à la troisième ligne de l'élément balun combineur à travers une troisième capacité afin de constituer une deuxième ligne de transmission unique, et que la deuxième ligne de l'élément balun diviseur soit connecté à la deuxième ligne de l'élément balun combineur à travers une deuxième capacité afin de constituer une troisième ligne de transmission unique;
- les impédances de fermeture des lignes de grilles du balun diviseur et du balun combineur sont supprimées afin de réaliser lesdites trois lignes de transmission; le balun actif réciproque comportant des moyens configurables pour polariser les différentes cellules amplificatrices de façon à induire un sens de couplage déterminé entre la première et la deuxième ligne de transmission d'une part et entre la première et la troisième ligne de transmission d'autre part;
   un premier couplage actif étant ainsi réalisé entre la première et la deuxième ligne de transmission au moyen de cellules amplificatrices réparties de type "cascode" des éléments baluns diviseur et combineur, et un second couplage actif étant ainsi réalisé entre la première et la troisième ligne de transmission au moyen de cellules amplificatrices réparties de type "Darlington" des éléments baluns diviseur et combineur.

Selon l'invention, dans un mode de fonctionnement où le dispositif exerce la fonction de balun diviseur, les moyens pour polariser les cellules amplificatrices sont configurés, commandés, de façon à ce qu'ils activent les cellules amplificatrices assurant le couplage directif dans l'élément balun diviseur et qu'ils désactivent les cellules amplificatrices assurant le couplage directif dans l'élément balun combineur.

Selon l'invention, dans un mode de fonctionnement où le dispositif exerce la fonction de balun combineur, les moyens pour polariser les cellules amplificatrices sont configurés, commandés, de façon à ce qu'ils désactivent les cellules amplificatrices assurant le couplage directif dans l'élément balun diviseur et qu'ils activent les cellules amplificatrices assurant le couplage directif dans l'élément balun combineur.

Le dispositif selon l'invention présente l'avantage de constituer un élément actif réciproque permettant de réaliser sur commande l'une ou l'autre des fonctions de balun diviseur ou de balun combineur.

Avantageusement le caractère réciproque du dispositif vient s'ajouter aux caractéristiques de large bande passante et de large gamme de fonctionnement des baluns actifs non réciproques connus de l'art antérieur.

Les caractéristiques et avantages de l'invention seront mieux appréciés grâce à la description qui suit, description qui expose l'invention au travers d'un mode de réalisation particulier pris comme exemple non limitatif et qui s'appuie sur les figures annexées, figures qui représentent:
- la figure 1, un schéma présentant la structure d'un mélangeur doublement équilibré réalisé à partir d'un pont de transistors à effet de champ, mélangeur utilise des baluns passifs à base de transformateurs selon l'art antérieur connu;
- la figure 2, un schéma illustrant la structure du balun de Marchand;
- la figure 3, un schéma illustrant la structure connue d'un balun actif large bande non réciproque, constitué à partir d'une structure distribuée formant des lignes couplées de manière active, dans une configuration de balun diviseur;
- la figure 4, un schéma illustrant la structure connue d'un balun actif large bande non réciproque, constitué à partir d'une structure distribuée formant des lignes couplées de manière active, dans une configuration de balun combineur;
- la figure 5, la structure du balun actif large bande et réciproque selon l'invention;
- la figure 6, l'illustration de la mise en oeuvre du balun actif réciproque selon l'invention, en mode "balun diviseur";
- la figure 7, l'illustration de la mise en oeuvre du balun actif réciproque selon l'invention, en mode "balun combineur";

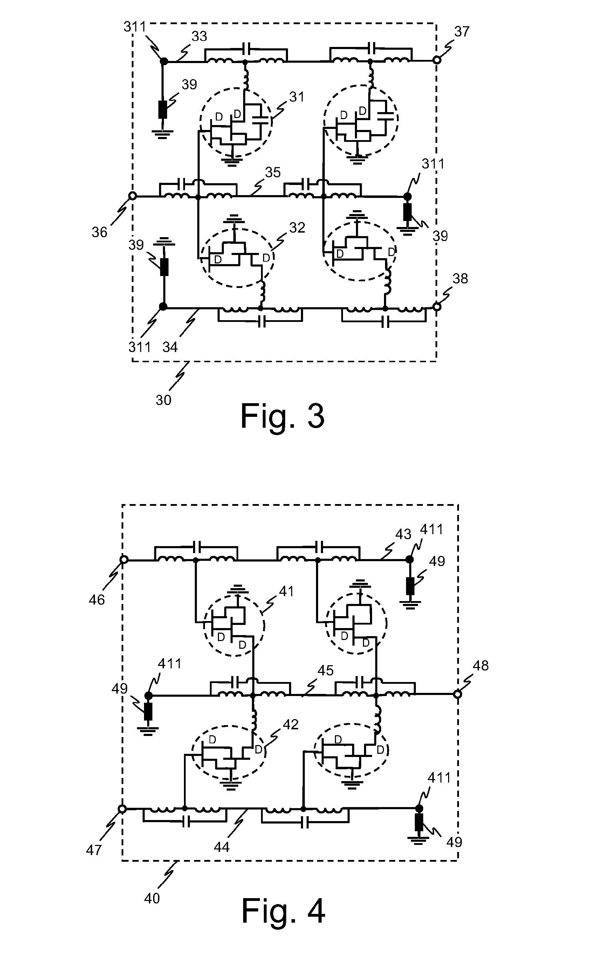

On s'intéresse dans un premier temps aux figures 3 et 4 qui présentent de manière schématique les deux structures distribuées actives à l'origine du dispositif selon l'invention.

Ces deux structures de base sont très largement décrites dans la demande de brevet français déposée par la demanderesse le 21 /12/ 2005 et publiée sous le numéro 2 895 168. Leur fonctionnement n'est donc pas détaillé ici, et l'on se contente d'en rappeler les points importants. La figure 3 présente une première structure arrangée pour constituer un balun actif non réciproque formant un dispositif diviseur, tandis que la figure 4 présente une seconde structure arrangée pour constituer un balun actif non réciproque formant un dispositif combineur.

La structure de la figure 3 comporte à cet effet trois lignes de transmission 33, 34 et 35, couplées au moyen de cellules actives 31 et 32, amplificatrices, représentées de manière schématique sur la figure, chaque cellule amplificatrice étant formée de transistors (transistors à effet de champ par exemple) assemblés pour former un montage de type "cascode" (cellules 32) ou de type "Darlington" (cellules 31). Ces deux types de montage sont connus pour présenter, l'un par rapport à l'autre, une phase différentielle d'environ 180° en transmission.

Les cellules 31 et 32 sont en outre polarisées de façon à réaliser un couplage actif et directif entre la ligne principale 35 (ligne de grille) et les lignes secondaires 33 et 34 (lignes de drain). De la sorte, un signal présent sur la ligne 35 est en mesure de se propager par couplage actif sur les lignes 33 et 34, la réciproque n'étant pas possible. Le signal appliqué sur l'entrée 36 du dispositif se propage ainsi sur les deux lignes secondaires 33 et 34 couplées à la ligne 35 sous forme de deux signaux en opposition de phase, signaux qui sont délivrés sur les sorties 37 et 38 respectives de chacune des lignes.

De manière similaire, la structure de la figure 4 comporte également à cet effet trois lignes de transmission 43, 44 et 45, couplées au moyen de cellules actives 41 et 42, amplificatrices, représentées de manière schématique sur la figure, chaque cellule étant formée de transistors (transistors à effet de champ par exemple) assemblés pour former un montage de type "cascode" (cellules 42) ou de type "Darlington" (cellules 41). Les cellules 41 et 42 sont en outre polarisées de façon à réaliser un couplage actif entre les lignes secondaires 43 et 44 (lignes de grille) et la ligne principale 45 (ligne de drain). De la sorte, des signaux présents sur les lignes 43 et 44 sont en mesure de se propager par couplage sur la ligne 45, la réciproque n'étant pas possible. Les signaux appliqués sur les entrées 46 et 47 du dispositif se propagent ainsi par couplage sur la ligne principale 45 et forment un signal combiné correspondant à la différence des 2 signaux d'entrée du fait de la différence intrinsèque de 180° entre les phases des montages de type "cascode" et de type "Darlington", qui est délivré sur la sortie 48.

Dans ces deux structures, un couplage actif est ainsi réalisé au moyen de cellules 32, 42, de type "cascode" et de cellules 31, 41, de type "Darlington" distribuées entre une ligne de grille et une ligne de drain. Le nombre de cellule est par ailleurs déterminé, en particulier par les caractéristiques de couplage et de gain désirées. Les illustrations des figures 3 et 4 présentent à titre d'exemple non limitatif des lignes comportant deux cellules. Les lignes de propagation ainsi formées sont en outre terminées à leurs extrémités non utilisées par des charges terminales 39, 49.

Comme il a été dit précédemment, ces deux structures actives permettent avantageusement de réaliser des baluns présentant une large bande passante et pouvant fonctionner pour des fréquences basses, typiquement à partir d'une centaine de mégahertz. En revanche, les baluns ainsi constitués présentent l'inconvénient de pas être réciproques dans leur fonctionnement, de sorte que selon que l'on souhaite réaliser la division d'un signal en deux signaux ou bien la recombinaison de deux signaux en un seul signal, il est nécessaire de mettre en oeuvre des dispositifs différents. Par suite lesdits dispositifs étant réalisés sous forme de circuits intégrés, on est conduit à employer deux types de circuits différents.

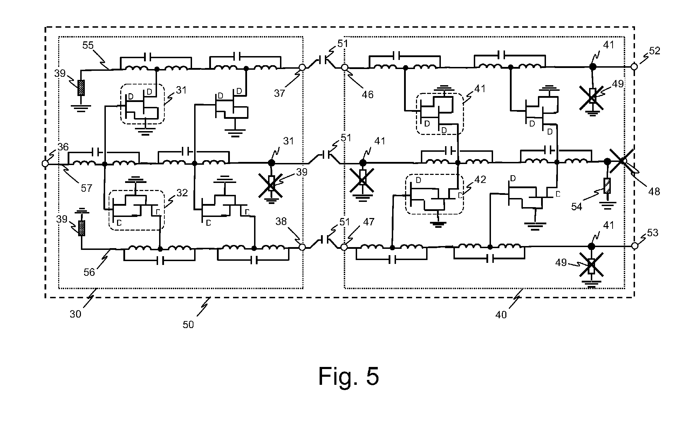

On s'intéresse ensuite à la figure 5 qui présente le schéma de principe du balun actif réciproque selon l'invention.

Comme l'illustre la figure 5, l'architecture du balun réciproque selon l'invention, est constitué à la base par l'association de l'architecture d'un balun actif 30 de type diviseur et de celle d'un balun actif 40 de type combineur. L'association de ces deux architectures est tout d'abord réalisée en reliant les sorties 37 et 38 des lignes de propagation 33 et 34 du balun diviseur 30, aux entrées 46 et 47 des lignes de propagation 43 et 44 du balun combineur 40. Elle est ensuite complétée par la connexion des lignes communes de chacune des structures, autrement dit par la connexion de la ligne de grille 35 du balun diviseur à la ligne de drain 45 du balun combineur.

II est important de noter que pour un bon fonctionnement de la structure, en particulier pour pouvoir commander indépendamment les cellules des baluns diviseur et combineur, chaque liaison entre ces lignes se fait au travers d'un condensateur 51. L'association de ces deux architectures est encore complétée par la suppression des charges d'adaptation 39 et 49 implantées aux extrémités 311 et 411, initialement non utilisées, des lignes principales 35 et 45 et des lignes secondaires 33, 34 et 43, 44. Dans le dispositif selon l'invention ces extrémités sont utilisées pour réaliser l'interconnexion des deux lignes communes 35 et 45, ainsi que pour constituer deux points de connexion des ports 52 et 53 permettant la connexion du dispositif à un circuit extérieur. Elle est enfin complétée par la suppression de la sortie 48 du circuit combineur initial 40 et par la mise en place d'une charge d'adaptation 54.

On obtient ainsi une structure duale 50, comportant un élément diviseur mis en série avec un élément combineur et comportant trois ports 36, 52 et 53. Cette structure constitue trois lignes de propagation 55, 56 et 57, les lignes 55 et 56 étant couplées à la ligne 57 par des cellules actives à transistors. Avantageusement, cette structure duale permet de réaliser aussi bien un balun actif diviseur qu'un balun actif combineur, les ports 36, 52 et 53 jouant alternativement le rôle d'entrées ou de sorties. La suite de la description explique comment la structure selon l'invention peut être mise en oeuvre pour réaliser l'une ou l'autre fonction.

Dans le dispositif selon l'invention, balun actif et réciproque, le couplage de la ligne 55 à la ligne 57 est réalisé par des cellules actives de type "Darlington", 31 et 41. Les cellules amplificatrices 31 permettent un couplage directif de la ligne 57 vers la ligne 55, et les cellules amplificatrices 41 un couplage directif de la ligne 55 vers la ligne 57. De même, le couplage de la ligne 56 à la ligne 57 est réalisé par des cellules actives amplificatrices de type "cascode", 32 et 42. Les cellules 32 permettent un couplage directif de la ligne 57 vers la ligne 56, et les cellules 42 un couplage directif de la ligne 56 vers la ligne 57. Cet agencement des cellules actives n'est pas, par ailleurs, le seul possible, le dispositif fonctionnant également en permutant les cellules 41 et 42.

Pour assurer le fonctionnement de cette architecture duale, le dispositif selon l'invention comporte également des moyens, non représentés sur la figure 5, pour assurer, en fonction du mode de fonctionnement désiré (balun diviseur ou balun combineur), la polarisation correspondante des différentes cellules actives 31, 32, 41 et 42. Selon l'invention, tout moyen permettant de polariser soit dans un état actif (ou "passant") soit dans un état inactif les différentes cellules réalisant le couplage actif, peut ici être utilisé. Ce moyen peut par exemple consister en un dispositif de commande qui, en fonction de la valeur d'une tension de commande appliquée sur une entrée du dispositif selon l'invention, polarise les différentes cellules de façon à établir un sens de couplage approprié au mode de fonctionnement considéré.

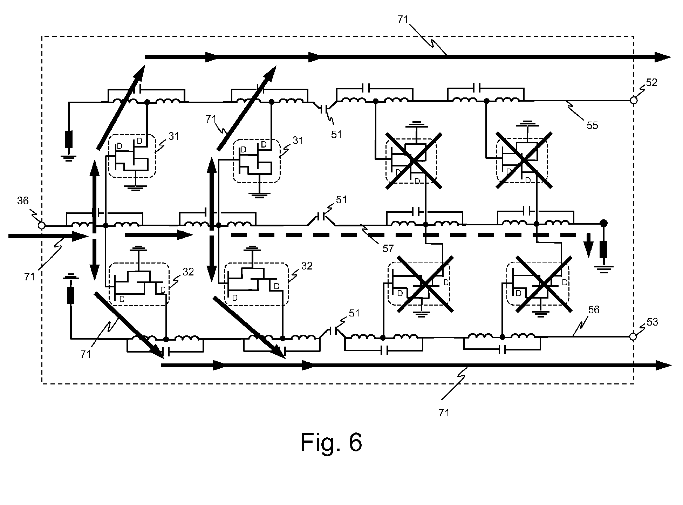

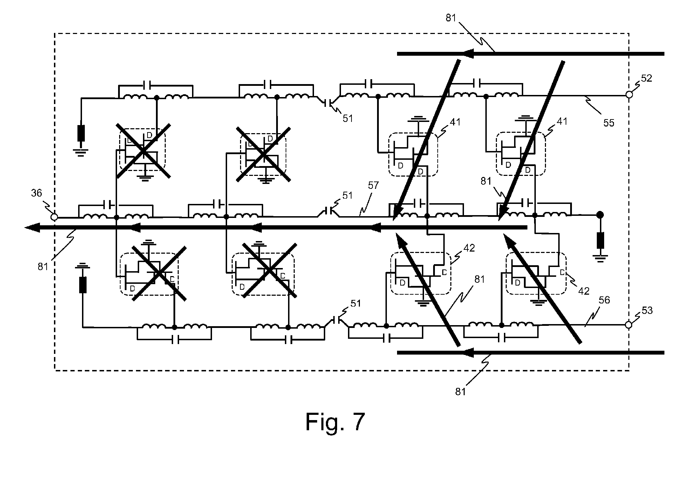

II est important de rappeler que lorsqu'une ligne (une ligne de grille ou une ligne de drain) ou une portion de ligne est connectée à des cellules polarisées dans l'état "inactif", cette ligne devient purement passive, découplée de toute autre ligne parallèle à elle, et qu'un signal peut se propager le long de cette ligne, dans l'un ou l'autre sens, en subissant peu d'atténuation. Les figures 6 et 7 illustrent la description des deux modes de fonctionnement qui caractérisent l'invention.

La figure 6 illustre de manière schématique le fonctionnement du dispositif selon l'invention lorsque celui-ci est configuré pour fonctionner en balun diviseur. Dans cette première configuration, les cellules amplificatrices 31 et 32 sont polarisée de façon à ce qu'elles réalisent un couplage actif de la ligne 57 aux lignes 55 et 56, tandis que les cellules amplificatrices 41 et 42 sont polarisées de façon à être inactives. Ainsi comme l'illustre la figure, si l'on applique un signal à l'entrée 36 de la ligne 57, celui-ci se propage par couplage actif sur les lignes 55 et 56 jusqu'au sorties 52 et 53 du dispositif, comme l'illustre les flèches 71. Dans cette première configuration, les cellules actives de l'élément diviseur sont donc polarisées de façon à assurer l'amplification du signal entre la ligne 57 (ici ligne de grille) d'entrée et les deux lignes de sortie 55 et 56 (ici lignes de drain). L'élément diviseur étant constitué de cellules "cascode" 32 et de cellules "Darlington" 31, le signal entrant sur sa ligne de grille par le port d'entrée 36 est bien divisée en deux signaux de même amplitude et en opposition de phase, disponibles sur les ports de sortie 52 et 53.

Inversement, les cellules actives de l'élément combineur sont polarisées de telle sorte que les étages d'amplification qui les constituent isolent les lignes 55 et 56 de la ligne 57, empêchant ainsi toute recombinaison au niveau de la ligne 57 des signaux circulant sur ces lignes.

La figure 7 illustre de manière schématique le fonctionnement du dispositif selon l'invention lorsque celui-ci est configuré pour fonctionner en balun combineur. Dans cette première configuration, les cellules 41 et 42 sont polarisées de façon à ce qu'elles réalisent un couplage actif des lignes 55 et 56 à la ligne 57, tandis que les cellules 31 et 32 sont polarisées de façon à être inactives. Ainsi comme l'illustre la figure, si l'on applique des signaux aux entrées 52 et 53 des lignes 55 et 56, ceux-ci se combinent par couplage actif sur la ligne 57; le signal résultant de la combinaison se propageant jusqu'à la sortie 36 du dispositif, comme l'illustre les flèches 81. Dans cette seconde configuration, les cellules actives de l'élément combineur sont donc polarisées de façon à assurer l'amplification du signal entre les 2 lignes 55 et 56 (ici lignes de grille) et la ligne 57 (ici ligne de drain). L'élément combineur étant constitué de cellules amplificatrices "cascode" 42 et de cellules amplificatrices "Darlington" 41, deux signaux entrant sur les 2 lignes de grille 55 et 56, avec des amplitudes identiques et des phases opposées sont sommés sur la ligne 57, le signal somme étant délivré sur le port de sortie 36 du dispositif.

Inversement, les cellules actives, amplificatrices, de l'élément diviseur sont polarisées de telle sorte que les étages d'amplification qui les constituent isolent la ligne 57 des lignes 55 et 56, empêchant ainsi toute propagation du signal recombiné par couplage sur les lignes 55 et 56.

Le dispositif selon l'invention se comporte donc comme un balun actif et réciproque.

## Revendications

1. Balun actif réciproque comportant:
- un élément balun diviseur actif comportant trois lignes (35, 34, 33), formant deux structures amplificatrices distribuées, chaque structure comportant une première ligne de transmission (35) commune avec l'autre structure, la première structure distribuée étant réalisée au moyen de cellules amplificatrices (32) de type "cascode" réparties, connectées à la première ligne de transmission (35) et à une deuxième ligne de transmission (34) de façon à permettre un couplage actif non réciproque du signal de la première ligne (35) à la deuxième ligne (34), la seconde structure distribuée étant réalisée au moyen de cellules amplificatrices (31) de type "Darlington" réparties, connectées entre la première ligne (35) et une troisième ligne de transmission (33), de façon à permettre un couplage actif non réciproque du signal de la première ligne (35) à la troisième ligne (33);
- un élément balun actif combineur comportant trois lignes (43, 44, 45), formant deux structures amplificatrices distribuées, chaque structure comportant une première ligne de transmission (45) commune avec l'autre structure, la première structure distribuée étant réalisée au moyen de cellules amplificatrices (42) de type "cascode" réparties, connectées à la première ligne de transmission (45) et à une deuxième ligne de transmission (44) de façon à permettre un couplage actif non réciproque du signal de la deuxième ligne (44) à la première ligne (45), la seconde structure distribuée étant réalisée au moyen de cellules amplificatrices (41) de type "Darlington" réparties, connectées à la première ligne de transmission (45) et à une troisième ligne de transmission (43) de façon à permettre un couplage actif non réciproque du signal de la troisième ligne (43) à la première ligne (45);
**caractérisé en ce que**:
- les éléments balun diviseur et balun combineur sont agencés de façon à ce que la ligne commune (35) de l'élément balun diviseur soit connecté à la ligne commune (45) de l'élément balun combineur à travers une première capacité (51) afin de constituer une première ligne de transmission unique (57), que la troisième ligne (33) de l'élément balun diviseur soit connecté à la troisième ligne (43) de l'élément balun combineur à travers une troisième capacité (51) afin de constituer une deuxième ligne de transmission unique (55), et que la deuxième ligne (34) de l'élément balun diviseur soit connecté à la deuxième ligne (44) de l'élément balun combineur à travers une deuxième capacité (51) afin de constituer une troisième ligne de transmission unique (56);
- les impédances de fermeture des lignes de grilles du balun diviseur (39) et du balun combineur (49) sont supprimées afin de réaliser lesdites trois lignes de transmission (55, 56 et 57); le balun actif réciproque comportant des moyens configurables pour polariser les différentes cellules amplificatrices (31, 41, 32 et 42) de façon à induire un sens de couplage déterminé entre la première et la deuxième ligne de transmission d'une part et entre la première et la troisième ligne de transmission d'autre part;
un premier couplage actif étant ainsi réalisé entre la première (57) et la deuxième (56) ligne de transmission au moyen de cellules amplificatrices réparties (32, 42) de type "cascode" des éléments baluns diviseur et combineur, et un second couplage actif étant ainsi réalisé entre la première (57) et la troisième (55) ligne de transmission au moyen de cellules amplificatrices réparties (31, 41) de type "Darlington" des éléments baluns diviseur et combineur.

2. Dispositif selon la revendication 1 **caractérisé en ce que**, dans un mode de fonctionnement diviseur, les moyens pour polariser les cellules amplificatrices sont configurés pour activer les cellules amplificatrices (31, 32) assurant un couplage directif dans l'élément balun diviseur et pour désactiver les cellules amplificatrices (41, 42) assurant le couplage directif dans l'élément balun combineur.

3. Dispositif selon la revendication 1 **caractérisé en ce que**, dans un mode de fonctionnement combineur, les moyens pour polariser les cellules amplificatrices sont configurés pour activer les cellules amplificatrices (41, 42) assurant un couplage directif dans l'élément balun combineur et pour désactiver les cellules amplificatrices (31, 32) assurant le couplage directif dans l'élément balun diviseur.

## Patentansprüche

1. Reziproker aktiver Balun, aufweisend:
- ein aktives teilendes Balunelement, das drei Leitungen (35, 34, 33) aufweist, die zwei verteilte Verstärkungsstrukturen bilden, wobei jede Struktur eine erste, mit der anderen Struktur gemeinsame Übertragungsleitung (35) aufweist, wobei die erste verteilte Struktur mit Hilfe aufgeteilter Verstärkungszellen (32) vom Typ "Kaskode" realisiert ist, die mit der ersten Übertragungsleitung (35) und mit einer zweiten Übertragungsleitung (34) derart verbunden sind, um eine nicht reziproke aktive Kopplung des Signals der ersten Leitung (35) mit der zweiten Leitung (34) zu erlauben, wobei die zweite verteilte Struktur mit Hilfe aufgeteilter Verstärkungszellen (31) vom Typ "Darlington" realisiert ist, die zwischen der ersten Leitung (35) und einer dritten Übertragungsleitung (33) derart verbunden sind, um eine nicht reziproke aktive Kopplung des Signals der ersten Leitung (35) mit der dritten Leitung (33) zu erlauben,
- ein aktives kombinierendes Balunelement, das drei Leitungen (43, 44, 45) aufweist, die zwei verteilte Verstärkungsstrukturen bilden, wobei jede Struktur eine erste, mit der anderen Struktur gemeinsame Übertragungsleitung (45) aufweist, wobei die erste verteilte Struktur mit Hilfe aufgeteilter Verstärkungszellen (42) vom Typ "Kaskode" realisiert ist, die mit der ersten Übertragungsleitung (45) und mit einer zweiten Übertragungsleitung (44) derart verbunden sind, um eine nicht reziproke aktive Kopplung des Signals der zweiten Leitung (44) mit der ersten Leitung (45) zu erlauben, wobei die zweite verteilte Struktur mit Hilfe aufgeteilter Verstärkungszellen (41) vom Typ "Darlington" realisiert ist, die mit der ersten Übertragungsleitung (45) und mit einer dritten Übertragungsleitung (43) derart verbunden sind, um eine nicht reziproke aktive Kopplung des Signals der dritten Leitung (43) mit der ersten Leitung (45) zu erlauben, **dadurch gekennzeichnet, dass**:
- das teilende Balunelement und das kombinierende Balunelement derart ausgebildet sind, dass die gemeinsame Leitung (35) des teilenden Balunelements mit der gemeinsamen Leitung (45) des kombinierenden Balunelements mittels einer ersten Kapazität (51) verbunden sind, um eine erste einzige Übertragungsleitung (57) zu bilden, dass die dritte Leitung (33) des teilenden Balunelements mit der dritten Leitung (43) des kombinierenden Balunelements mittels einer dritten Kapazität (51) verbunden ist, um eine zweite einzige Übertragungsleitung (55) zu bilden, und dass die zweite Leitung (34) des teilenden Balunelements mit der zweiten Leitung (44) des kombinierenden Balunelements mittels einer zweiten Kapazität (51) verbunden ist, um eine dritte einzige Übertragungsleitung (56) zu bilden;
- die Verschlussimpedanzen der Gitterleitungen des teilenden Baluns (39) und des kombinierenden Baluns (49) unterdrückt werden, um die drei Übertragungsleitungen (55, 56 und 57) zu realisieren; wobei der reziproke aktive Balun Mittel aufweist, die konfigurierbar sind, um die verschiedenen Verstärkungszellen (31, 41, 32 und 42) zu polarisieren, so dass eine bestimmte Kopplungsrichtung zwischen der ersten und der zweiten Übertragungsleitung einerseits und zwischen der ersten und der dritten Übertragungsleitung andererseits induziert wird;
wobei dadurch eine erste aktive Kopplung zwischen der ersten (57) und der zweiten (56) Übertragungsleitung mit Hilfe aufgeteilter Verstärkungszellen (32, 42) vom Typ "Kaskode" der teilenden und kombinierenden Balunelemente realisiert wird, und
wobei dadurch eine zweite aktive Kopplung zwischen der ersten (57) und der dritten (55) Übertragungsleitung mit Hilfe aufgeteilter Verstärkungszellen (31, 41) vom Typ "Darlington" der teilenden und kombinierenden Balunelemente realisiert wird.

2. Vorrichtung nach Anspruch 1, **dadurch gekennzeichnet, dass** in einem teilenden Funktionsmodus die Mittel zur Polarisierung der Verstärkungszellen konfiguriert sind, um die Verstärkungszellen (31, 32) zu aktivieren, die eine direktive Kopplung im teilenden Balunelement sichern, und um die Verstärkungszellen (41, 42) zu deaktivieren, die die direktive Kopplung im kombinierenden Balunelement sichern.

3. Vorrichtung nach Anspruch 1, **dadurch gekennzeichnet, dass** in einem kombinierenden Funktionsmodus die Mittel zur Polarisierung der Verstärkungszellen konfiguriert sind, um die Verstärkungszellen (41, 42) zu aktivieren, die eine direktive Kopplung im kombinierenden Balunelement sichern, und um die Verstärkungszellen (31, 32) zu deaktivieren, die die direktive Kopplung im teilenden Balunelement sichern.

## Claims

1. Reciprocal active balun, having:
an active splitter balun element having three lines (35, 34, 33), forming two distributed amplifier structures, each structure having a first transmission line (35) in common with the other structure, the first distributed structure being made by means of distributed cascode amplifier cells (32), connected to the first transmission line (35) and to a second transmission line (34) so as to permit the non-reciprocal active coupling of the signal from the first line (35) to the second line (34), the second distributed structure being made by means of distributed Darlington amplifier cells (31), connected between the first line (35) and a third transmission line (33) so as to permit a non-reciprocal active coupling of the signal from the first line (35) to the third line (33);
an active combiner balun element having three lines (43, 44, 45), forming two distributed amplifier structures, each structure having a first transmission line (45) in common with the other structure, the first distributed structure being made by means of distributed cascode amplifier cells (42), connected to the first transmission line (45) and to a second transmission line (44) so as to permit the non-reciprocal active coupling of the signal from the second line (44) to the first line (45), the second distributed structure being made by means of distributed Darlington amplifier cells (41), connected to the first transmission line (45) and to a third transmission line (43) so as to permit a non-reciprocal active coupling of the signal from the third line (43) to the first line (45);
**characterized in that**:
the splitter balun and combiner balun elements are arranged in such a way that the common line (35) of the splitter balun element is connected to the common line (45) of the combiner balun element through a first capacitor (51) to form a first single transmission line (57), the third line (33) of the splitter balun element is connected to the third line (43) of the combiner balun element through a third capacitor (51) to form a second single transmission line (55), and the second line (34) of the splitter balun element is connected to the second line (44) of the combiner balun element through a second capacitor (51) to form a third single transmission line (56);
the terminating impedances of the gate lines of the splitter balun (39) and of the combiner balun (49) are removed in order to produce said three transmission lines (55, 56 and 57);
the reciprocal active balun having configurable means for polarizing the different amplifier cells (31, 41, 32 and 42) so as to provide a specific direction of coupling between the first and the second transmission line on one hand, and between the first and the third transmission line on the other hand;
a first active coupling thus being provided between the first (57) and the second (56) transmission line by means of distributed cascode amplifier cells (32, 42) of the splitter and combiner balun elements, and
a second active coupling thus being provided between the first (57) and the third (55) transmission line by means of distributed Darlington amplifier cells (31, 41) of the splitter and combiner balun elements.

2. Device according to claim 1, **characterized in that**, for operation in splitter mode, the means for polarizing the amplifier cells are configured to activate the amplifier cells (31, 32) providing the directive coupling in the splitter balun element, and to deactivate the amplifier cells (41, 42) providing the directive coupling in the combiner balun element.

3. Device according to claim 1, **characterized in that**, for operation in combiner mode, the means for polarizing the amplifier cells are configured to activate the amplifier cells (41, 42) providing the directive coupling in the combiner balun element, and to deactivate the amplifier cells (31, 32) providing the directive coupling in the splitter balun element.
